# EUROPEAN PATENT APPLICATION

(11) **EP 0 655 708 A1**
(43) Date of publication of application: **31.05.1995**
(21) Application number: 93309415.3
(22) Date of filing: 25.11.1993
(51) Int. Cl.: G06K 15/12, H04N 1/191

(54) **Semiconductor laser exposure device**

(71) Applicant: THINK LABORATORY CO., LTD., Kashiwa-City, Chiba-Prefecture (JP)
(72) Inventor: Taniura, Hiroshi, Ibaraki-Prefecture (JP)
(74) Representative: Thomson, Paul Anthony

(57) **Abstract**

A semiconductor laser exposure device, said device having a scanning table (1) on which are mounted a semiconductor laser array (2) which radiates laser beams on to an exposed object W, a lens array (3) mounted at a distance A away from the semiconductor laser array (2), a first condensing lens (4) mounted at a distance B away from the lens array (3); a second condensing lens (5) mounted at a distance C away from the first condensing lens (4); and an autofocus lens (fi) mounted a distance D away from the second condensing lens (5); and the said semiconductor laser array (2) being equipped with the required number of semiconductor lasers arranged in parallel to enable laser beams to be radiated in parallel at required pitch (t) between the required optical axes, the said lens array (3) being comprised of lenses arranged in parallel, the pitch (t) between the lens centers being the same as the pitch between the optical axes of the said laser beams, the lenses having the function of widening the expansion angle of the laser beams emitted from the said semiconductor lasers, the distance B between the said lens array (3) and the said first condensing lens (4) being determined to enable an appropriate amount of overlapping to occur between the laser beams adjacent to each other when the laser beams reach the widened center of the said first condensing lens (4) after the aperture of the lens is expanded by the said lens array (3); the distance C between the said first condensing lens (4) and the said second condensing lens (5) being determined at a distance where the focal length (f1) of the first condensing lens (4) and the focal length (f2) of the second condensing lens (5) are added; the distance D between the said second condensing lens (5) and the said autofocus lens (6) being determined at a distance where the focal length (f2) of the second condensing lens (5) and the focal length (f3) of the autofocus lens (6) are added; the distance between the said autofocus lens (6) and the said exposed object (W) being determined to be identical to the focal length (f3) of the autofocus lens (6) after the said scanning table (1) is shifted towards the X-axis direction prior to the exposure, and is also identical to the focal length (f3) during the exposure utilising the autofocus function of the autofocus lens (6).

## Description

This invention relates to a semiconductor laser exposure device which can conduct a plurality of laser beam exposures by utilizing a semiconductor laser array where a plurality of laser beams overlap each other one by one sideways.

Conventional semiconductor laser exposure devices are designed so that one laser beam is emitted on to either a silver chloride film rolled around a drum or a photosensitive film coated plate roll and adopt a singular laser beam exposure system where the main scanning process (rotation) is conducted on to the drum or the roll and at the same time the laser beam is linearly sub-scanned along the drum; however, such conventional semiconductor laser beam exposure system requires a long exposure time.

If the number of laser beams are increased, the required time for exposure would be shortened only fractionally compared to using one laser beam. Accordingly, the possibility of increasing the number of laser beams by utilizing beam splitters has been considered. However, compared to an argon neon gas laser, the beam energy of a semiconductor laser is much too small to go through beam splitters. Accordingly mounting of a plurality of semiconductor lasers in parallel has been considered; however, the distance between the semiconductor lasers would be too large thereby creating difficulties in arranging the laser beams in a row overlapping one another. Accordingly, it may be possible to utilize not semiconductor lasers mounted in parallel but rather a semiconductor laser array where optical measurements can be taken by restraining the pitch of the laser beam to let the laser beams be emitted in a row overlapping one another transversely.

This invention has for an object the provision of a semiconductor laser exposure device which enables the exposure time to be greatly shortened by utilising a semiconductor laser array where a plurality of laser beams can overlap in a row, and a plurality of laser beam exposures is made possible by shifting the emission direction parallel or perpendicular to the direction of the said laser beams.

According to the present invention there is provided a semiconductor laser exposure device, said device having a scanning table on which are mounted a semiconductor laser array which radiates laser beams on to an exposed object W, a lens array mounted at a distance A away from the semiconductor laser array, a first condensing lens mounted at a distance B away from the lens array; a second condensing lens mounted at a distance C away from the first condensing lens; and an autofocus lens mounted a distance D away from the second condensing lens; and the said semiconductor laser array being equipped with the required number of semiconductor lasers arranged in parallel to enable laser beams to be radiated in parallel at the required pitch between the required optical axes, the said lens array being comprised of lenses arranged in parallel, the pitch between the lens centers being the same as the pitch between the optical axes of the said laser beams, the lenses having the function of widening the expansion angle of the laser beams emitted from the said semiconductor lasers, the distance B between the said lens array and the said first condensing lens being determined to enable an appropriate amount of overlapping to occur between the laser beams adjacent to each other when the laser beams reach the widened center of the said first condensing lens after the aperture of the lens is expanded by the said lens array; the distance C between the said first condensing lens and the said second condensing lens being determined at a distance where the focal length of the first condensing lens and the focal length of the second condensing lens are added; the distance D between the said second condensing lens and the said autofocus lens being determined at a distance where the focal length of the second condensing lens and the focal length of the autofocus lens are added; the distance between the said autofocus lens and the said exposed object W being determined to be identical to the focal length of the autofocus lens after the said scanning table 1 is shifted towards the X-axis direction prior to the exposure, and is also identical to the focal length of said autofocus lens during the exposure utilizing the autofocus function of the autofocus lens.

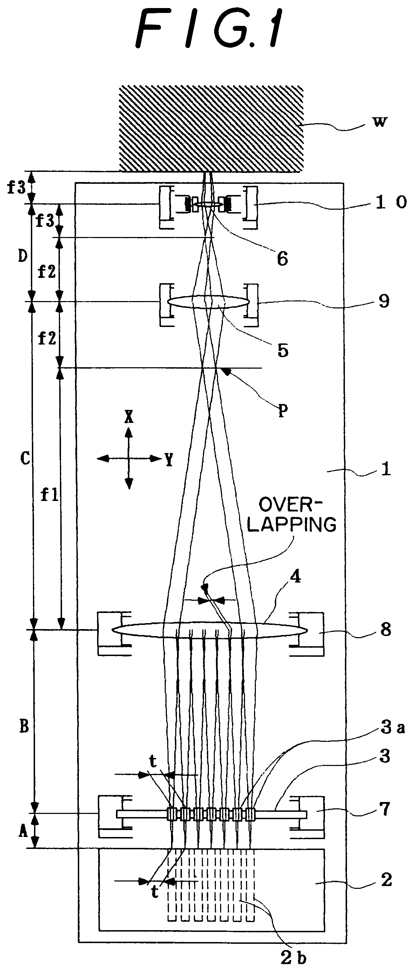

The present invention will be further illustrated, by way of example, with reference to the accompanying drawing, in which the single Figure schematically illustrates a semiconductor laser exposure device in accordance with the invention.

As illustrated, the exposed object W is depicted as a plate roll on which a photosensitive film is coated or a silver chloride film is wrapped around a revolving drum. The said exposed object W is scanned and rotated by a servo-motor (not shown). Scanning table 1 is capable of moving in the X-axis direction to move closer to or further away from the exposed object W, and is also capable of moving in the Y-axis direction parallel to the exposed face of the object W. The movement of the scanning table 1 in the Y-axis direction is a sub-scanning, designed to shift by as much as the width of the row of laser beams per one rotation of the exposed object W. However if, for example, the exposed object W is an offset planograph, it is desirable to have the scanning table 1 in the form of a three-dimensional table. Semiconductor laser array 2, which emits laser beams, is mounted on the said scanning table 1. Lens array 3 is also mounted on said table 1 a distance A away from the semiconductor laser array 2, the lens array 3 being supported by supporting means 7 for minor adjustment. A first condensing lens 4 is mounted on said table 1 a distance B away from lens array 3, the lens being supported by supporting means 8 for minor adjustment. A second condensing lens 5 is mounted on said table 1 a distance C away from the first condensing lens 4 and is supported by supporting means 9 for minor adjustment. An autofocus lens 6 is mounted on said table 1 a distance D away from the second condensing lens 5 and is supported by supporting means 10 for minor adjustment. Accordingly, the laser beam emitted from the semiconductor laser array 2 is transmitted through lens array 3, the first condensing lens 4, the second condensing lens 5 and the autofocus lens 6, to irradiate on the exposed object W. The semiconductor laser array 2 is constructed so that the required number of semiconductor lasers 2a,2a,..... are arranged in parallel to enable the laser beam to be radiated in parallel at a pitch t between the required optical axes. Lens array 3 is designed to have the pitch between the central parts of the lens part 3a to be identical to pitch t between the optical axes of the laser beams, and each lens part 3a has the function of widening the laser beam angle of the laser beam emitted from semiconductor lasers 2a,2a,... The lens parts 3a,3a,... of the said lens array 3 is a series of fiber lenses (either optical fiber or reduced plastic fiber) arranged in a sideways row, but it is also possible to substitute the fiber lens with minor concave lenses or minor non-spherical lenses. The distance B between the lens array 3 and the first condensing lens 4 is determined so that an appropriate amount of overlapping will occur between adjacent laser beams when the laser beam, the beam angle of which is expanded by the lens array 3, reaches the widened central part of the first condensing lens 4. The degree of overlapping could be as small as just touching between adjacent laser beams, but preferably, the overlapping should occur within the range of 0.293d at least to 0.5d at maximum, d being the radius of the laser beam. The distance C between the first condensing lens 4 and the second condensing lens 5 is determined at a distance where the focal length f1 of the first condensing lens 4 and the focal length f2 of the second condensing lens 5 are added. Distance D between the second condensing lens 5 aid the autofocus lens 6 is determined at a distance where the focal length f2 of the second condensing lens 5 and the focal length f3 of the autofocus lens 6 are added. The distance between autofocus lens 6 and the exposed object W is designed to be identical with the focal length f3 of the autofocus lens 6 after adjusting the said scanning table 1 to the X-axis direction prior to exposure. The position of the autofocus lens 6 is controlled in the optical axis direction by a voice coil or an electrical perversive actuator, lens 6 is designed to be identical with the focal length f3 with its autofocus function during exposure.

In operation, prior to the exposure, the position of the X-Y scanning table 1 is adjusted in the X-axis direction to synchronize the distance between the autofocus lens 6 and the exposed object W to be that of the focal length f3 of the autofocus lens 6. The exposed object W is then scanned and rotated, and at the same time scanning table 1 is scanned and adjusted in the Y-axis direction, and the semiconductor laser array 2 is switch driven on and off based on the image data. The laser beam emitted from the semiconductor laser array 2 is transmitted through the lens array 3, the first condensing lens 4, the second condensing lens 5 and the autofocus lens 6, and the laser beam irradiates on to the exposed object W, exposing the image based on the image data. The plurality of laser beams emitted in parallel from the semiconductor laser array 2 is transmitted through each lens part of the lens array 3 and the widened angle of the light becomes larger, creating an overlap at an appropriate degree with the adjacent laser beam when reaching the center part of the first condensing lens 4, and the beams unite together to form one line of beams at position P where the beams are transmitted through the said first condensing lens 4 and after the beams proceeding for focal length f2 of the said first condensing lens 4, and furthermore, to enable the beams to cross, the beam proceeds for the focal length f2 of the second condensing lens 5 and is then transmitted through the said second condensing lens 5 and proceeds furthermore by a distance of focal length f2 of the second condensing lens 5 and irradiates on to the exposed object W and causes exposure. The lines of the laser beams emitted on to the exposed object W will be a few tenths or a few fractions of the line width of the overlapped laser beam when reaching the center part of the first condensing lens 4. Therefore, the laser beams reaching the center part of the first condensing lens 4 will overlap with adjacent laser beams thus creating a row of overlapping beams, and this overlapping row of beams will be irradiated on to the exposed object W after being reduced to a few tenths or fractions by the second condensing lens and the autofocus lens 6.

As explained above, by utilising the semiconductor laser exposure device of the invention a plurality of laser beams can overlap each other in a row by utilising a semiconductor laser array, and multiple laser beam exposure is made possible by transferring the light emitted in the direction parallel to or transverse to the row of the laser beams, and thus it is possible to reduce the time required for exposure.

## Claims

1. A semiconductor laser exposure device, said device having a scanning table (1) on which are mounted a semiconductor laser array (2) which radiates laser beams on to an exposed object W, a lens array (3) mounted at a distance A away from the semiconductor laser array (2), a first condensing lens (4) mounted at a distance B away from the lens array (3); a second condensing lens (5) mounted at a distance C away from the first condensing lens (4); and an autofocus lens (fi) mounted a distance D away from the second condensing lens (5); and the said semiconductor laser array (2) being equipped with the required number of semiconductor lasers arranged in parallel to enable laser beams to be radiated in parallel at the required pitch (t) between the required optical axes, the said lens array (3) being comprised of lenses arranged in parallel, the pitch (t) between the lens centers being the same as the pitch between the optical axes of the said laser beams, the lenses having the function of widening the expansion angle of the laser bears emitted from the said semiconductor lasers, the distance B between the said lens array (3) and the said first condensing lens (4) being determined to enable an appropriate amount of overlapping to occur between the laser beams adjacent to each other when the laser beams reach the widened center of the said first condensing lens (4) after the aperture of the lens is expanded by the said lens array (3); the distance C between the said first condensing lens (4) and the said second condensing lens (5) being determined at a distance where the focal length (f1) of the first condensing lens (4) and the focal length (f2) of the second condensing lens (5) are added; the distance D between the said second condensing lens (5) and the said autofocus lens (6) being determined at a distance where the focal length (f2) of the second condensing lens (5) and the focal length (f3) of the autofocus lens (6) are added; the distance between the said autofocus lens (6) and the said exposed object (W) being determined to be identical to the focal length (f3) of the autofocus lens (6) after the said scanning table (1) is shifted towards the X-axis direction prior to the exposure, and is also identical to the focal length (f3) during the exposure utilizing the autofocus function of the autofocus lens (6).
